# EUROPÄISCHE PATENTSCHRIFT

(11) **EP 2 585 836 B1**
(45) Veröffentlichungstag und Bekanntmachung des Hinweises auf die Patenterteilung: **22.08.2018**
(21) Anmeldenummer: 11723458.3
(22) Anmeldetag: 03.06.2011
(51) Int. Cl.: G01R 13/02

(54) **MESSVORRICHTUNG MIT EINER TRIGGEREINHEIT**
MEASURING DEVICE HAVING A TRIGGER UNIT
DISPOSITIF DE MESURE COMPRENANT UN MODULE DE DÉCLENCHEMENT

(30) Priorität: 21.09.2010 DE 102010046098; 23.06.2010 DE 102010024708
(43) Veröffentlichungstag der Anmeldung: 01.05.2013
(73) Patentinhaber: Rohde & Schwarz GmbH & Co. KG, 81671 München (DE)
(72) Erfinder: FREIDHOF, Markus, 85614 Kirchseeon (DE)
(74) Vertreter: Körfer, Thomas
(86) Internationale Anmeldenummer: PCT/EP2011/059191
(87) Internationale Veröffentlichungsnummer: WO 2011/160935

(56) Entgegenhaltungen:
- EP-A2- 0 663 597
- EP-A2- 0 740 161
- EP-A2- 1 672 794
- DE-A1-102005 035 473
- US-A1- 2007 282 542
- US-A1- 2009 222 771
- Joachim Bitzer Digitaltechnik: "Windows Software für Tiepie Oszilloskopprodukte", , Nr. 2.0 Januar 2002 (2002-01), Seiten 1-117, XP000002657786, Gefunden im Internet: URL:http://web.archive.org/web/20040611055 712/http://www.tiepie.de/download/manuals/ winsoft.pdf [gefunden am 2011-08-29]
- TSUNG-PO CHEN: "Common-Mode Ripple Current Estimator for Parallel Three-Phase Inverters", IEEE TRANSACTIONS ON POWER ELECTRONICS, IEEE SERVICE CENTER, PISCATAWAY, NJ, US, Bd. 24, Nr. 5, 1. Mai 2009 (2009-05-01), Seiten 1330-1339, XP011257106, ISSN: 0885-8993

## Beschreibung

Die vorliegende Erfindung bezieht sich auf eine Messvorrichtung zur digitalen Triggerung von einem mit Rauschsignalen überlagerten Messsignal und kann innerhalb eines Aufzeichnungsgeräts, beispielsweise innerhalb einem digitalen Oszilloskop, verwendet werden.

Zur phasen- bzw. zeitkorrekten Darstellung eines Messsignals auf einem Aufzeichnungsgerät, beispielsweise einem digitalen Oszilloskop, ist eine Triggerung erforderlich, die beispielsweise über einen Triggerschwellwert den auf dem Aufzeichnungsgerät darzustellenden Signalabschnitt des Messsignals identifiziert und über ein daraus abgeleitetes Triggersignal zum Triggerzeitpunkt die Aufzeichnung des Messsignals auf dem Aufzeichnungsgerät initiiert.

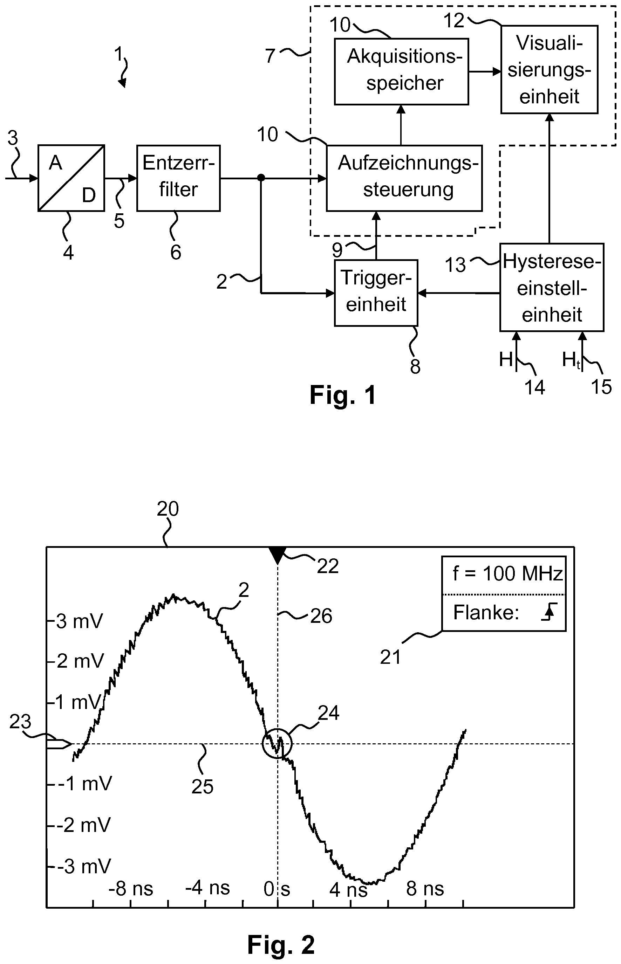

Problematisch sind allerdings Störungen, die dem zu messenden Signal als Rauschen überlagert sind. Solche Störungen, wie sie in Fig. 2 dargestellt sind, können dafür sorgen, dass der Trigger eines Oszilloskops fälschlicherweise ausgelöst wird. In Fig. 2 soll auf eine steigende Signalflanke getriggert werden, allerdings löst der Trigger bei einer fallenden Flanke des zu messenden Signals auch aus, weil eine Störung mit steigender Flanke dem zu messenden Signal auf Höhe der Triggerschwelle überlagert ist. Bei einer fortlaufenden Triggerung, entstehen dadurch sogenannte Schattenbilder, weil das darzustellende Messsignal in seiner Position aufgrund der Fehltriggerungen nicht fixiert ist. Diese wirken dabei störend auf den Benutzer, der das Messsignal auswerten möchte, bzw. eine automatisierte Auswertung der Messdaten wird beim Auftreten von Fehltriggerungen (fälschlich erkanntes Triggerereignis) deutlich erschwert.

Um eine solche Fehltriggerung zu vermeiden, müssen im Triggersystem eines Oszilloskops Komparatoren mit Hysterese eingesetzt werden. Je größer dabei das Eigenrauschen des Oszilloskops ist, umso größer muss die Hysterese dabei gewählt werden.

Aus der DE 10 2006 027 835 A1 ist eine Triggerschaltung (dt. Auslöseschaltung) bekannt, die Fehltriggerungen dadurch verringert, dass Komparatoren mit Hysterese verwendet werden. Sobald das zu messende Signal eine obere Hystereseschwelle überschreitet, wird ein Zeitgeber gestartet. Unterschreitet das Messsignal innerhalb einer festen Zeitspanne nicht die untere Hystereseschwelle, dann wird ein Triggerimpuls ausgegeben. Wird die untere Hystereseschwelle unterschritten, bevor die Zeitspanne des Zeitgebers verstrichen ist, dann wird kein Triggersignal ausgelöst.

Nachteilig an der DE 10 2006 027 835 A1 ist, dass die Hystereseschwellen nicht beliebig verstellt werden können, um dadurch unterschiedlich stark gestörte Messsignale dennoch sicher triggern zu können.

Bei dem Dokument "Windows Software für TP-Oszilloskopprodukte", Joachim Bitzer Digitaltechnik, verändert der Benutzer unter Verwendung des Mauszeigers, der linken sowie der rechten Maustaste die Position eines Balkens eines Triggersymbols, wobei das Triggersymbol beabstandet von dem Messsignal am Rand des Bildschirms angeordnet ist.

Die EP 0 740 161 A2 beschreibt eine analoge Triggereinheit für ein digitales Oszilloskop. Die analoge Triggereinheit ist mit zwei analogen Komparatoren aufgebaut. Dieses Dokument zeigt zwei verschiedene Triggerzustände, wobei bei Überschreiten des Triggerzustands "high level" der Ausgang Q des Flip-Flops den Zustand "high" annimmt, wohingegen bei Unterschreiten des Zustands "low-level" der Zustand den Zustand "high" annimmt. Bei den Zuständen "high-level" und "low-level" handelt es sich nicht um den Hysteresebereich, sondern einzig um zwei verschiedene Triggerzustände.

Die EP 0 663 597 A2 offenbart auch eine analoge Triggereinheit. Es ist dort beschrieben, dass ein Hysteresebereich entsprechend des Rauschgrades eines Messsignals einstellbar sein sollte. Die Einstellbarkeit des Hysteresebereichs wird dabei aber nicht näher erläutert.

Es ist daher die Aufgabe der Erfindung eine Vorrichtung und ein Verfahren zur digitalen Triggerung eines von einem mit Rauschsignalen überlagerten Messsignals zu schaffen, die es erlauben, unterschiedlich stark gestörte Messsignale sicher zu Triggern.

Die Aufgabe wird bezüglich der Messvorrichtung durch die Merkmale des Anspruchs 1 und bezüglich des Verfahrens durch die Merkmale des Anspruchs 8 gelöst. In den Unteransprüchen sind vorteilhafte Weiterbildungen der erfindungsgemäßen Messvorrichtung und des erfindungsgemäßen Verfahren zur digitalen Triggerung von einem mit Rauschsignalen überlagerten Messsignal angegeben.

Die erfindungsgemäße Messvorrichtung zur Triggerung eines mit einem Rauschsignal überlagerten Messsignals weist eine Triggereinheit auf, die mit einer Aufzeichnungseinheit verbunden ist, wobei beiden das jeweils mit einem Rauschsignal überlagerte Messsignal zugeführt ist, wobei die Triggereinheit ein Triggersignal an die Aufzeichnungseinheit ausgibt, sobald das mit einem Rauschsignal überlagerte Messsignal einen Hysteresebereich vollständig durchläuft. Weiterhin ist die Triggereinheit mit einer Hystereseeinstelleinheit verbunden, wobei die Hystereseeinstelleinheit einen Hysteresebereich der Triggereinheit vorgibt und wobei der von der Hystereseeinstelleinheit vorgegebene Hysteresebereich einstellbar ist.

Besonders vorteilhaft ist es, wenn die Hystereseeinstelleinheit direkt mit der Triggereinheit verbunden ist, weil dadurch die Triggereinheit entsprechend auf unterschiedlich stark gestörte Messsignale angepasst werden kann. Dies erfolgt erfindungsgemäß dadurch, dass ein Wert für den Hysteresebereich beliebig wählbar ist und der Hystereseeinstelleinheit vorgegeben wird, d.h. einstellbar ist. Unter einstellbar ist u.a. zu verstehen, dass der Wert während der Messung der Hysteresebereich fortlaufend auf einen anderen Wert änderbar ist. Dadurch wird erreicht, dass sich das dazustellende Messsignal trotz dem überlagerten Rauschen sehr schnell einstellt.

Das erfindungsgemäße Verfahren zur Triggerung eines mit einem Rauschsignal überlagerten Messsignals weist eine Triggereinheit und eine Aufzeichnungseinheit auf, die miteinander verbunden sind, wobei beiden das jeweils mit einem Rauschsignal überlagerte Messsignal zugeführt ist. Die Triggereinheit ist außerdem weiterhin mit einer Hystereseeinstelleinheit verbunden. In einem ersten Verfahrensschritt werden Parameter, wie der Zeit- und/oder der Pegelbereich, z.B. der Spannungsbereich oder der Strombereich, eingestellt. In einem zweiten Verfahrensschritt wird der Hysteresebereich für die Triggereinheit durch die Hystereseeinstelleinheit eingestellt, wobei die Triggereinheit ein Triggersignal an die Aufzeichnungseinheit ausgibt, sobald das mit einem Rauschsignal überlagerte Messsignal den Hysteresebereich innerhalb der Triggereinheit vollständig durchläuft.

Besonders vorteilhaft ist es dabei, wenn der Hysteresebereich eingestellt werden kann, weil der Hysteresebereich dabei dynamisch während der Messung an die unterschiedlichsten Messsignale angepasst werden kann. Dadurch, dass das Triggersignal erst dann ausgeben wird, wenn der Hysteresebereich vollständig von dem Messsignal durchlaufen ist, kann bei Wahl eines größeren Hysteresebereichs die Wahrscheinlichkeit für eine versehentliche Triggerung verringert werden.

Ein weiterer Vorteil der erfindungsgemäßen Messvorrichtung besteht, wenn die Hystereseeinstelleinheit einen Zeitbereich innerhalb der Triggereinheit beliebig einstellt, wobei die Triggereinheit das Triggersignal an die Aufzeichnungseinheit nur ausgibt, wenn eine Triggerschwelle genau einmal zu Beginn des Zeitbereichs über- oder unterschritten ist. Wird die Triggerschwelle innerhalb des Zeitbereichs mehrmals über- oder unterschritten, so deutet dies auf Störungen hin, die dem Messsignal überlagert sind und es wird kein Triggersignal ausgegeben. Dadurch ist sichergestellt, dass die Triggereinheit auch bei Störungen unterschiedlicher Frequenz optimal arbeitet.

Außerdem besteht bei der erfindungsgemäßen Messvorrichtung ein Vorteil, wenn die Aufzeichnungseinheit eine Visualisierungseinheit aufweist, die mit der Hystereseeinstelleinheit verbunden ist und den eingestellten Hysteresebereich und/oder den eingestellten Zeitbereich anzeigt. Dadurch ist auf besonders einfache Weise die Triggerung der Messvorrichtung verfeinerbar, um Fehltriggerungen durch vorhandene Störungen zu minimieren.

Schlussendlich besteht bei der erfindungsgemäßen Messvorrichtung ein Vorteil, wenn der Hysteresebereich und/oder der Zeitbereich in absoluten Werten oder in Divisionen (Anzeigesegmenten) einstellbar ist. Für den Fall, dass der Hysteresebereich und/oder der Zeitbereich in absoluten Werten einstellt ist, kann sehr schnell erkannt werden, bei welchen Größen für die eingestellten Werte die Störungen verschwinden, um dadurch Rückschlüsse auf die Art der Störungen zu ziehen. Andererseits ist der Hysteresebereich und/oder der Zeitbereich auch in Divisionen einstellbar, so dass der Hysteresebereich und/oder der Zeitbereich bei einer Skalierung der Messvorrichtung automatisch mit skaliert werden.

Zusätzlich besteht bei dem erfindungsgemäßen Verfahren ein Vorteil, wenn ein Zeitbereich innerhalb der Triggereinheit durch die Hystereseeinstelleinheit eingestellt wird, so dass die Triggereinheit das Triggersignal an die Aufzeichnungseinheit nur ausgibt, wenn eine Triggerschwelle genau einmal zu Beginn des Zeitbereichs über- oder unterschritten ist. Neben dem Einstellen eines Hysteresebereichs ist es möglich, die Triggereinheit durch Variation des Zeitbereichs derart einzustellen, dass Störungen unterschiedlicher Frequenz nicht mehr wie bisher zu Fehltriggerungen führen.

Schlussendlich besteht bei dem erfindungsgemäßen Verfahren ein Vorteil, wenn es sich bei der Triggereinheit um eine digitale Triggereinheit handelt und/oder wenn das mit einem Rauschsignal überlagerte Messsignal digitalisiert ist. Bei Verwendung einer analogen Triggereinheit, ist diese aus analogen Komparatoren aufgebaut. Ein Hysteresebereich kann daher nur durch Verstellen der Widerstände im Rückkopplungspfad eingestellt werden, was wiederum zusätzliches Rauschen mit sich bringt. Bei dem Aufbau einer digitalen Triggereinheit, kann daher der Hysteresebereich problemlos bitgenau eingestellt werden. Außerdem steht das Messsignal bereits zu Beginn in digitalisierter Form zu Verfügung, was wiederum die weitere Signalverarbeitung erheblich vereinfacht und wodurch auf eine Vielzahl von analogen Bauteilen verzichtet werden kann, was mit einer Kostensenkung und einem weniger komplexen Aufbau einhergeht. Gleichzeitig wird eine höhere Flexibilität erreicht, weil die digitale Signalverarbeitung durch Änderungen im Programmablaufplan schnell an weitere Einsatzgebiete angepasst werden kann.

Verschiedene Ausführungsbeispiele der Erfindung werden nachfolgend unter Bezugnahme auf die Zeichnung beispielhaft beschrieben. Gleiche Gegenstände weisen dieselben Bezugszeichen auf. Die entsprechenden Figuren der Zeichnung zeigen im Einzelnen:
- Fig. 1: ein Blockschaltbild eines Ausführungsbeispiels der erfindungsgemäßen Messvorrichtung zur digitalen Triggerung einer Aufzeichnung eines mit einem Rauschsignal überlagerten Messsignals;
- Fig. 2: ein Bildschirmausschnitt eines Ausführungsbeispiels einer Messvorrichtung ohne die erfindungsgemäße Triggereinheit mit fehlerhaft ausgelöster Triggerung;
- Fig. 3: ein Bildschirmausschnitt eines Ausführungsbeispiels der erfindungsgemäßen Messvorrichtung mit aktiviertem Hysteresebereich;
- Fig. 4A: einen Bildschirmausschnitt eines Ausführungsbeispiels, der die Funktionsweise der erfindungsgemäßen Messvorrichtung mit aktiviertem Hysteresebereich bei steigender Flanke verdeutlicht;
- Fig. 4B: einen Bildschirmausschnitt eines Ausführungsbeispiels, der die Funktionsweise der erfindungsgemäßen Messvorrichtung mit aktiviertem Hysteresebereich bei fallender Flanke verdeutlicht;
- Fig. 5: ein Bildschirmausschnitt eines Ausführungsbeispiels der erfindungsgemäßen Messvorrichtung mit aktiviertem Hysteresebereich und richtig ausgelöstem Trigger;
- Fig. 6: ein Bildschirmausschnitt eines Ausführungsbeispiels der erfindungsgemäßen Messvorrichtung mit aktiviertem Hysteresebereich und aktiviertem Zeitbereich;
- Fig. 7A: einen Bildschirmausschnitt eines Ausführungsbeispiels, der die Funktionsweise der erfindungsgemäßen Messvorrichtung mit aktiviertem Hysteresebereich und aktiviertem Zeitbereich bei steigender Flanke verdeutlicht;
- Fig. 7B: einen weiteren Bildschirmausschnitt eines Ausführungsbeispiels, der die Funktionsweise der erfindungsgemäßen Messvorrichtung mit aktiviertem Hysteresebereich bei steigender Flanke verdeutlicht;
- Fig. 7C: einen Bildschirmausschnitt eines Ausführungsbeispiels, der die Funktionsweise der erfindungsgemäßen Messvorrichtung mit aktiviertem Hysteresebereich bei fallender Flanke verdeutlicht;
- Fig. 7D: einen weiteren Bildschirmausschnitt eines Ausführungsbeispiels, der die Funktionsweise der erfindungsgemäßen Messvorrichtung mit aktiviertem Hysteresebereich bei fallender Flanke verdeutlicht; und
- Fig. 8: ein beispielhaftes Ablaufdiagramm, welches das erfindungsgemäße Verfahren für die Messvorrichtung beschreibt.

Ein erfindungsgemäßes Ausführungsbeispiel der Messvorrichtung 1 zur digitalen Triggerung eines digitalisierten, mit einem Rauschsignal überlagerten Messsignals 2, ist in Fig. 1 dargestellt und wird im Folgenden näher beschrieben.

Das analoge Messsignal 3 mit überlagertem Rauschen wird in einem Analog/Digital-Wandler 4 in sein korrespondierendes Datenformat gewandelt. In einem anschließenden Entzerrungsfilter 6 erfolgt eine Entzerrung des linear, bzw. nichtlinear verzerrten digitalen Messsignals 5.

Das mit einem Rauschsignal überlagerte Messsignal 2 am Ausgang des Entzerrungsfilters 6 wird an die Aufzeichnungseinheit 7 und gleichzeitig an die Triggereinheit 8 weitergeleitet. Optional kann zwischen das Entzerrungsfilter 6 und die Aufzeichnungseinheit 7 noch eine Dezimationseinheit eingeführt werden, die das mit einem Rauschsignal überlagerte Messsignal 2 am Ausgang des Entzerrungsfilters 6 komprimiert, indem nur jeder n-te Abtastwert des mit einem Rauschsignal überlagerten Messsignals 2 an die Aufzeichnungseinheit 7 weitergeleitet wird. Dadurch können, wenn auch mit verminderter Auflösung, längere Zeiträume betrachtet werden, ohne dass der Analog/Digital-Wandler 4 in seiner Abtastfrequenz verlangsamt werden müsste.

In einem weiteren nicht dargestellten erfindungsgemäßen Ausführungsbeispiel kann zwischen dem Entzerrungsfilter 6 und der Triggereinheit 8 noch ein Tiefpassfilter ausgebildet sein. Im Tiefpassfilter wird insbesondere das gegenüber dem Messsignal 2 höherfrequente Rauschsignal bandbegrenzt. Auf diese Weise wird die Varianz des Rauschsignals reduziert.

Dennoch kann man bei Verwendung eines Tiefpassfilters und einer Dezimationseinheit davon sprechen, dass es sich bei dem Signal am Ausgang des Tiefpassfilters und am Ausgang der Dezimationseinheit um das mit einem mehr oder weniger starken Rauschen überlagerte Messsignal 2 handelt, weil die Triggereinheit 8 zwangsläufig auf das Messsignal 2 triggern muss. Dies gilt auch für den Fall, dass noch weitere Komponenten innerhalb des Signalpfads zwischen dem analogen Messsignal 3 und dem der Triggereinheit 8 und der Aufzeichnungseinheit 7 zugeführten digitalisierten Messsignal 2 vorhanden sind.

In der Triggereinheit 8 wird das Messsignal 2 mit überlagertem Rauschsignal mit einstellbaren Schwellwerten zur Erzeugung eines Triggersignals 9 verglichen. Das Triggersignal 9 wird anschließend an die Aufzeichnungseinheit 7 weitergeleitet, indem die Triggereinheit 8 mit der Aufzeichnungseinheit 7 über eine Datenverbindung verbunden ist.

Die Aufzeichnungseinheit 7 weist eine Aufzeichnungssteuerung 10 auf, der das Messsignal 2 mit überlagertem Rauschsignal von dem Entzerrungsfilter 6 und das Triggersignal 9 von der Triggereinheit 8 zugeführt sind. Die Aufzeichnungssteuerung 10 beinhaltet noch einen nicht dargestellten Ringpuffer, in welchem die Abtastwerte des Messsignals 2 mit überlagertem Rauschsignal abgespeichert sind.

Weiterhin weist die Aufzeichnungseinheit 7 einen Akquisitionsspeicher 11 auf, der mit der Aufzeichnungssteuerung 10 verbunden ist. Sobald die Aufzeichnungseinheit 7 das Triggersignal 9 von der Triggereinheit 8 empfängt, werden die entsprechenden Abtastwerte des mit einem Rauschsignal überlagerten Messsignals 2 durch die Aufzeichnungssteuerung 10 innerhalb der Aufzeichnungseinheit 7 in den Akquisitionsspeicher 11 der Aufzeichnungseinheit 7 gespeichert.

Außerdem weist die Aufzeichnungseinheit 7 noch eine Visualisierungseinheit 12 auf, die mit dem Akquisitionsspeicher 11 verbunden ist. Die Visualisierungseinheit 12 stellt auf einem nicht dargestellten Bildschirm die von der Aufzeichnungssteuerung 10 innerhalb der Aufzeichnungseinheit 7 selektierten Abtastwerte des mit einem Rauschsignal überlagerten Messsignals 2 dar.

Die Messvorrichtung 1 verfügt weiterhin noch über eine Hystereseeinstelleinheit 13, die mit der Triggereinheit 8 und der Visualisierungseinheit 12 über eine Datenverbindung verbunden ist. Der Hystereseeinstelleinheit 13 wird von außerhalb ein Wert für den einzustellenden Hysteresebereich 30 innerhalb der Triggereinheit 8 zugeführt. Dies ist über die Datenverbindung 14 dargestellt. Über die Datenverbindung 14 kann ein Benutzer einen beliebig einzustellenden Hysteresebereich 30 vorgeben. Die Datenverbindung 14 kann auch mit einem weiteren nicht dargestellten Computersystem verbunden sein, so dass ein einzustellender beliebiger Hysteresebereich 30 von diesem vorgegeben wird. Der durch die Hystereseeinstelleinheit 13 innerhalb der Triggereinheit 8 eingestellte Hysteresebereich 30 bewirkt, dass die digitalen Komparatoren innerhalb der Triggereinheit 8, die das mit einem Rauschsignal überlagerte Messsignal 2 mit einem Schwellwert vergleichen, erst umschalten, sobald der Hysteresebereich 30 vollständig von dem mit einem Rauschsignal überlagerten Messsignal 2 durchlaufen ist. Die Funktionsweise dieses Sachverhalts wird in den weiteren Figurenbeschreibungen noch ausführlich beschrieben.

Der Hysteresebereich 30 selbst kann dabei in absoluten Werten wie z.B. mV, V oder mA, bzw. A eingestellt werden. Ein Benutzer oder ein Computersystem kann einen Hysteresebereich 30 von z.B. 1 mV angeben, so dass das mit einem Rauschsignal überlagerte Messsignal 2 einen Bereich in Höhe von z.B. 1 mV unterhalb oder oberhalb der Triggerschwelle 25 bis hin zur Triggerschwelle 25 durchlaufen muss, damit die Triggereinheit 8 das Triggersignal 9 ausgibt. Natürlich ist es auch möglich, dass der Hysteresebereich 30 anstatt in absoluten Werten in Divisionen eingestellt wird. Dadurch wird der eingestellte Hysteresebereich 30 automatisch an den eingestellten Maßstab für die Messeinheit angepasst, sobald der Maßstab geändert wird.

Der Hystereseeinstelleinheit 13 wird im Weiteren über eine zweite Verbindung 15 noch ein beliebiger Zeitbereich 60 übergeben. Dieser Zeitbereich 60 kann ebenfalls wieder durch einen nicht dargestellten Benutzer oder ein nicht dargestelltes Computersystem vorgegeben werden. Die Hystereseeinstelleinheit 13 stellt im Weiteren entsprechend dem Wunsch des Benutzers oder des Befehls des Computersystems den Zeitbereich 60 innerhalb der Triggereinheit 8 ein. Dieser bewirkt, dass die Triggereinheit 8 nur dann ein Triggersignal 9 ausgibt, wenn die Triggerschwelle 25 zu Beginn des Zeitbereichs 60 nur einmal über- oder unterschritten wird. Bei mehrmaligem Über- oder Unterschreiten der Triggerschwelle 25 innerhalb des Zeitbereichs 60 wird kein Triggersignal 9 ausgegeben. Der Zeitbereich 60 kann ebenfalls einerseits wieder in absoluten Werten wie z.B. ns, ms oder s eingestellt werden. Andererseits besteht die Möglichkeit diesen in Divisionen vorzugeben, so dass auch bei Veränderung des Zeitmaßstabs der Zeitbereich 60 äquivalent dazu geändert wird. Die Funktionsweise des Zeitbereichs 60 wird in den weiteren Figurenbeschreibungen noch ausführlich erläutert.

Fig. 2 zeigt einen Bildschirmausschnitt 20 eines Ausführungsbeispiels der Messvorrichtung 1 ohne die erfindungsgemäße Triggereinheit 8 mit fehlerhaft ausgelöster Triggerung. Der Bildschirmausschnitt 20 zeigt stark vereinfacht die Bildschirmausgabe der Messeinheit 1, die der Benutzer beim Bedienen z.B. des Oszilloskops sieht. Dargestellt ist das mit einem Rauschsignal überlagerte Messsignal 2. Das Messsignal 2 hat eine Frequenz von z.B. ungefähr 100 MHz und eine Amplitude von etwas über 3 mV. Die Statusanzeige 21 zeigt, dass auf eine steigende Signalflanke des Messsignals 2 getriggert werden soll. Der Triggerzeitpunkt 26 wird durch den Cursor 22 visualisiert und liegt bei 0 s. Der Trigger 23 selbst ist auf eine Triggerschwelle 29 von 0 mV eingestellt. Zu erkennen ist, dass die Triggereinheit 8 auslöst, obwohl das Messsignal 2 eine fallende Signalflanke aufweist. Dies liegt daran, dass das Rauschen auf Höhe der Triggerschwelle 25 dem Messsignal 2 derart überlagert ist, dass kurzzeitig eine steigende Signalflanke 24 auftritt.

Der Einsatz eines Tiefpasses mindert zwar diese hochfrequenten Störungen, sorgt aber andererseits dafür, dass auch das eigentliche Messsignal 2 gedämpft sein kann. Möchte man mehrere Signale, die über verschiedene Kanäle z.B. in das Oszilloskop eingespeist werden, darstellen, wobei auf ein Signal getriggert werden soll, so kann der Phasengang des Tiefpasses dafür sorgen, dass die Signale nicht phasentreu zueinander dargestellt werden und die Messung dadurch verfälscht wird. Wird die Triggereinheit 8 von einer Einzelauflösung (manuell) wie in Fig. 2 dargestellt auf automatisch gestellt, dann kommt es durch das mehr oder weniger periodische Auftreten dieser Störungen zum Entstehen sogenannter Schattenbilder, also eines schnellen Wechsels der angezeigten Bilder bei einer richtig und einer falsch ausgelösten Triggerung. Der Benutzer hat den Eindruck, dass zwei Messsignale zu selben Zeit gemessen würden, die um 180° gegeneinander phasenverschoben sind, so dass eine Auswertung des eigentlichen Messsignals 2 nicht mehr möglich ist.

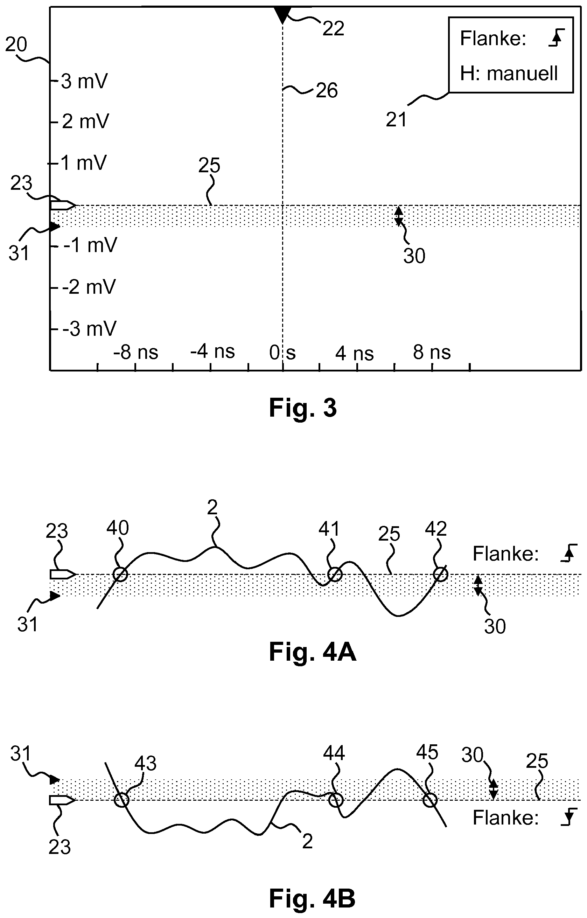

Fig. 3 zeigt einen Bildschirmausschnitt 20 eines Ausführungsbeispiels der erfindungsgemäßen Messvorrichtung 1 mit aktiviertem Hysteresebereich 30. Zu sehen ist, dass es neben dem Cursor 22, der den Triggerzeitpunkt 26 bestimmt und dem Cursor 23 für den Trigger, noch einen weiteren kleinen Cursor 31 gibt, welcher vom Cursor 23 des Triggers nach unten weg bewegt werden kann. Die Fläche zwischen Triggerschwellwert 25 und dem weiteren Cursor 31 symbolisiert den eingestellten Hysteresebereich 30 in den digitalen Komparatoren der Triggereinheit 8. Bei Verwendung einer digitalen Triggereinheit 8 sind verschiedene Werte für den Hysteresebereich 30 einstellbar. Bevorzugt sind derart viele Werte für den Hysteresebereich 30 einstellbar, wie es die Auflösung der Komparatoren erlaubt. Man spricht hierbei von einer bitgenauen Einstellung des Hysteresebereichs 31. Es auf der anderen Seite auch möglich, den Hysteresebereich 30 aus einem von verschiedenen voreingestellten Werten auszuwählen. Beispielsweise sind Werte für z.B. einen kleinen, einen mittleren und einen großen Hysteresebereich 30 gespeichert, die über entsprechende Bedienknöpfe am Gehäuse der Messvorrichtung 1 direkt ausgewählt werden können, wodurch sich die Einstellung der Messvorrichtung 1 beschleunigt. Eine weitere Möglichkeit besteht in der automatischen Auswahl des richtigen Hysteresebereichs 30 durch die Messvorrichtung 1 selbst.

Besonders vorteilhaft ist dabei, dass die Visualisierungseinheit 12 mit der Hystereseeinstelleinheit 13 verbunden ist und über diese Datenverbindung der eingestellte Hysteresebereich 30 an die Visualisierungseinheit 12 übertragen wird, die diese dem Benutzer auf einer nicht dargestellten Bildschirmeinheit anzeigt. Bevorzugt wird der eingestellte Hysteresebereich 30 von der Visualisierungseinheit 12 durch eine eingefärbte und/oder transparente Fläche unterhalb oder oberhalb der Triggerschwelle 25 dargestellt, je nachdem ob auf eine steigende oder eine fallende Signalflanke getriggert wird. Die Verschiebung des weiteren Cursors 31 für den Hysteresebereich 30 kann dabei während der Erfassung des Messsignals 2 erfolgen. Bevorzugt kann der Hysteresebereich 30 über einen Drehknopf während den laufenden Messungen anpasst werden.

Die Bedienung erfolgt dabei ganz intuitiv, weil sowohl das Messsignal 2, als auch der Hysteresebereich 30 durch die Visualisierungseinheit 12 auf der Bildschirmeinheit dargestellt werden. Sobald bei einer Triggerung keine Schattenbilder mehr auftreten, ist der Hysteresebereich 30 richtig gewählt. Die Fläche, die dem Hysteresebereich 30 entspricht, wird bevorzugt in einer Farbe dargestellt, die keinem der vorhandenen Messkanäle zugeordnet ist. Damit das Messsignal 2 noch gut wahrgenommen wird, sollte der Hysteresebereich 30 transparent zusammen mit einem geringeren Kontrast dargestellt sein.

Fig. 4A zeigt einen Teil des Bildschirmausschnitts 20 eines Ausführungsbeispiels, der die Funktionsweise der erfindungsgemäßen Messvorrichtung 1 mit aktiviertem Hysteresebereich 30 bei einer Triggerung auf eine steigende Signalflanke verdeutlicht. Dargestellt ist das mit einem Rauschen überlagerte Messsignal 2, welches an mehreren Stellen 40, 41 und 42 die Triggerschwelle 25 mit positiver Steigung überschreitet. An der Stelle 40 gibt die Triggereinheit 8 ein Triggersignal 9 aus, weil das Messsignal 2 den Hysteresebereich 30 vollständig durchläuft. Unter vollständig Durchlaufen ist hier zu verstehen, dass das Messsignal 2 den Bereich von dem weiteren Cursor 31 bis zur Triggerschwelle 25 durchlaufen muss. An der Stelle 41 wird indes kein Triggersignal 9 von der Triggereinheit 8 ausgegeben, weil der Hysteresebereich 30 nicht vollständig durchlaufen ist. Gut zu erkennen ist, dass die Triggereinheit 8 unempfindlicher wird, je größer der Hysteresebereich 30 gewählt wird. Ist ein Messsignal 2 mit starkem Rauschen überlagert, so kann bei ausreichend groß gewähltem Hysteresebereich 30 dennoch ein sicheres Triggern der Triggereinheit 8 gewährleistet werden. An der Stelle 42 wird wiederum ein Triggersignal 9 durch die Triggereinheit 8 ausgegeben, weil der Hysteresebereich 30 vollständig von dem Messsignal 2 durchlaufen ist.

Fig. 4B zeigt einen Teil des Bildschirmausschnitts 20 eines Ausführungsbeispiels, der die Funktionsweise der erfindungsgemäßen Messvorrichtung 1 mit aktiviertem Hysteresebereich 30 bei einer Triggerung auf eine fallende Signalflanke verdeutlicht. Ein Unterschied zwischen der Triggerung auf eine steigende Signalflanke, wie in Fig. 4A gezeigt, und der Triggerung auf eine fallende Signalflanke des Messsignals 2, wie in Fig. 4B gezeigt, besteht in der Richtung, in welche die Fläche, die den Hysteresebereich 30 symbolisiert, ausgerichtet ist. Bei der Triggerung auf die fallende Signalflanke befindet sich der weitere Cursor 31 zur Einstellung des Hysteresebereichs 30 oberhalb des Cursors 23 für die Einstellung des Triggerschwelle 25. Analog zu Fig. 4A wird in Fig. 4B in den Stellen 43 und 45 ein Triggersignal 9 durch die Triggereinheit 8 ausgegeben, weil der Hysteresebereich 30 vollständig durchlaufen ist. An der Stelle 44 wird kein Triggersignal 8 ausgegeben, weil der Hysteresebereich 30 eben nicht vollständig durchlaufen ist.

Sobald der Benutzer die Signalflanke, auf die getriggert werden soll, ändert, wird der weitere Cursor 31 an der Triggerschwelle 25, die sich horizontal entlang des Cursors 23 für den Trigger erstreckt, gespiegelt. Daher ist es nicht notwendig, dass jedes Mal, wenn die Signalflanke auf die getriggert wird, geändert wird, der Hysteresebereich 30 neu eingestellt werden muss.

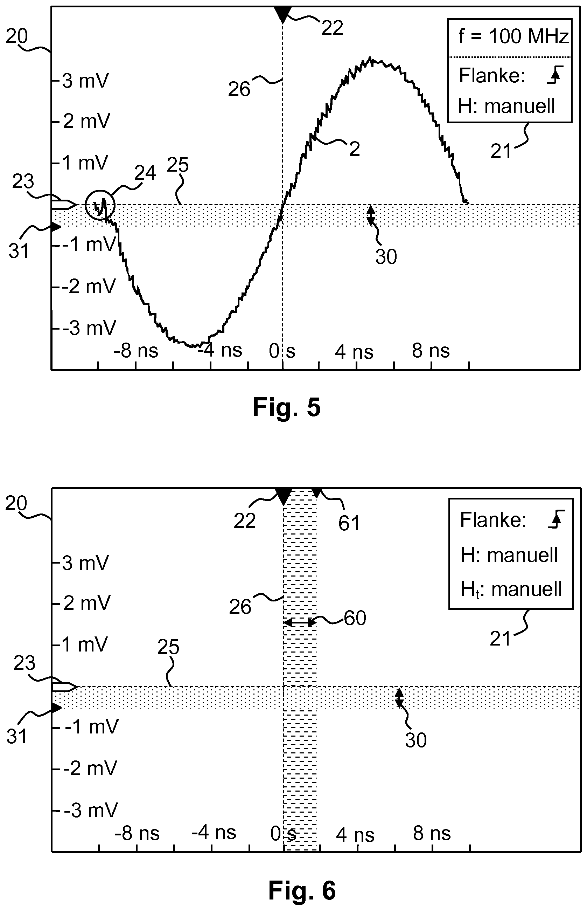

Fig. 5 zeigt ein Bildschirmausschnitt 20 eines Ausführungsbeispiels der erfindungsgemäßen Messvorrichtung 1 mit aktiviertem Hysteresebereich 30 und fehlerfrei ausgelöstem Trigger. Der Bildschirmausschnitt 20 aus Fig. 5 zeigt dasselbe Messsignal 2 wie es auch schon in Fig. 2 abgebildet ist. Der Unterschied besteht darin, dass in Fig. 5 der Hysteresebereich 30 innerhalb der digitalen Triggereinheit 8 aktiviert (H: manuell) ist, wie dies der Statusanzeige 21 zu entnehmen ist. Das Messsignal 2 an der Stelle 24, welche in Fig. 2 noch eine Fehltriggerung ausgelöst hat, durchläuft in Fig. 5 nicht mehr vollständig, wie anhand von Fig. 4A und 4B beschrieben, den Hysteresebereich 30, so dass die Triggereinheit 8 für die Stelle 24 kein Triggersignal 9 mehr ausgibt. Das Messsignal 2 wird daher richtig erfasst.

Fig. 6 zeigt ein Bildschirmausschnitt 20 eines Ausführungsbeispiels der erfindungsgemäßen Messvorrichtung 1 mit aktiviertem Hysteresebereich 30 (H: manuell) und aktiviertem Zeitbereich 60 (Hₜ: manuell). Für Erläuterungen den Hysteresebereich 30 betreffend wird auf die vorangegangenen Beschreibungen verwiesen. Neben dem Cursor 22 für den Triggerzeitpunkt 26, dem weiteren Cursor 31 für den Hysteresebereich 30 und dem Cursor 23 für den Trigger mit der Triggerschwelle 25, gibt es noch einen vierten Cursor 61 für den Zeitbereich 60. Der Cursor 61 für den Zeitbereich 60 ist auf der positiven Zeitachse neben dem Cursor 22 für den Triggerzeitpunkt 26 ausgebildet. Die Differenz zwischen dem Cursor 61 für den Zeitbereich 60 und dem Cursor 22 für den Triggerzeitpunkt 26 wird auch als der Zeitbereich 60 bezeichnet. Der eingestellte Zeitbereich 60 wird dabei von der Visualisierungseinheit 12 sichtbar dargestellt. Bevorzugt wird der Zeitbereich 60 dabei durch eine eingefärbte und/oder transparente Fläche auf der positiven Zeitachse neben dem Triggerzeitpunkt 26 dargestellt. Dabei ist die Fläche für den Zeitbereich 60 bevorzugt in einer anderen Farbe und/oder mit einem geringeren Kontrast dargestellt als die den Messkanälen zugewiesenen Farben innerhalb des z.B. einen Oszilloskops.

Der Zeitbereich 60 wird ebenfalls wie der Hysteresebereich 30 der Hystereseeinstelleinheit 13, durch den Benutzer oder durch ein angeschlossenes Computersystem vorgegeben und die Hystereseeinstelleinheit 13 stellt diesen dann in der Triggereinheit 8 ein und gibt ihn ebenfalls an die Visualisierungseinheit 12 weiter. Dabei sind verschiedene Werte für den Zeitbereich 60 einstellbar. Bevorzugt kann der Zeitbereich 60 beliebig eingestellt werden, wobei unter beliebig zu verstehen ist, dass der Zeitbereich 60 positiv sein muss und der Cursor 61 für den Zeitbereich 60 nicht in Schritten verstellbar ist, die kleiner sind, als die Abtastrate des Analog/Digital-Wandlers 4. Es kann auch davon gesprochen werden, dass der Zeitbereich 60 in sehr fein Schritten einstellbar ist. Es ist natürlich auch möglich, dass der Zeitbereich 60 aus einem von verschiedenen voreingestellten Werten auswählbar ist. Beispielsweise kann es Werte für z.B. 1 ns, 10 ns, 100 ns usw. geben, die über Bedienknöpfe direkt an dem z.B. Oszilloskop einstellbar sind, um dadurch die zeitaufwendigere und in manchen Fällen nicht notwendige Eingabe eines ganz speziellen Wertes für den Zeitbereich 60 zu vermeiden.

Der eingestellte Zeitbereich 60 bewirkt, dass die Triggereinheit 8 das Triggersignal 9 an die Aufzeichnungseinheit 7 nur dann ausgibt, wenn die Triggerschwelle 25 genau einmal im Triggerzeitpunkt 26 zu Beginn des Zeitbereichs 60 über- oder unterschritten ist. Der Zeitbereich 60 ist dabei, wie in Fig. 6 gezeigt, in absoluten Werten einstellbar. Es ist auch möglich, dass der Zeitbereich 60 in Divisionen einstellbar ist, so dass sich der Zeitbereich 60 gleichermaßen ändert, wenn der Maßstab neu eingestellt ist. Entspricht eine Division z.B. einer Zeitdauer von 1 ns und ist der Zeitbereich 60 auf eine Division eingestellt, dann entspricht der Zeitbereich 60 ebenfalls einer Zeitdauer von 1 ns beginnend ab dem Triggerzeitpunkt 26. Wird nun der Zeitmaßstab geändert, so dass eine Division im Weiteren 10 ns entspricht, dann erstreckt sich der Zeitbereich 60 von dem Triggerzeitpunkt 26 aus betrachtet um 10 ns entlang der positiven Zeitachse. Weiterhin ist es möglich, dass der Zeitbereich 60 ausgeblendet wird, nachdem dieser eingestellt ist. In diesem Fall kann optional der Wert für den eingestellten Zeitbereich 60 in der Statusanzeige 21 visualisiert sein. Selbiges gilt auch für den Hysteresebereich 30.

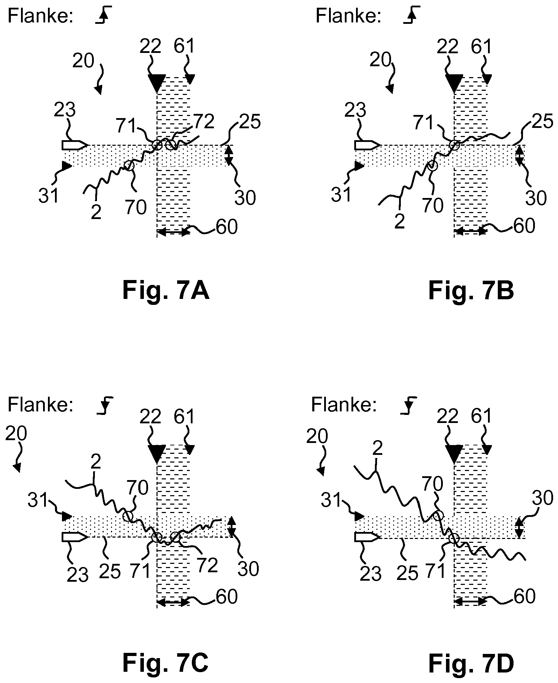

Fig. 7A, 7B, 7C und 7D erläutern detailliert die Funktionsweise der erfindungsgemäßen Triggereinheit 8 mit aktiviertem Hysteresebereich 30 und aktiviertem Zeitbereich 60 bei Triggerung auf eine steigende oder fallende Signalflanke des Messsignals 2.

In Fig. 7A ist die Triggereinheit 8 derart eingestellt, dass diese ein Triggersignal 9 ausgeben soll, sobald ein mit einem Rauschen überlagertes Messsignal 2 den Hysteresebereich 30 vollständig durchläuft und den durch den Cursor 23 für die Triggerschwelle 25 vorgegebenen Pegel überschreitet und innerhalb des Zeitbereichs 60 oberhalb der Triggerschwelle 25 bleibt. Zu erkennen ist, dass das Messsignal 2 zum Zeitpunkt 70 in den Hysteresebereich 30 eindringt und diesen Bereich zum Zeitpunkt 71 des Erreichens der Triggerschwelle 25 vollständig durchlaufen hat. Wäre kein Zeitbereich 60 vorgegeben, dann würde die Triggereinheit 8 zum Zeitpunkt 71 ein Triggersignal 9 an die Aufzeichnungseinheit 7 ausgeben. Allerdings ist in Fig. 7A ein Zeitbereich 60 durch den Benutzer eingestellt. Weil das Messsignal 2 zum Zeitpunkt 72 die Triggerschwelle 25 unterschreitet und weil der Zeitpunkt 72 noch innerhalb des Zeitbereichs 60 liegt, wird durch die Triggereinheit 8 im Folgenden kein Triggersignal 9 ausgegeben.

Fig. 7B zeigt ein Ausführungsbeispiel mit einem Bildschirmausschnitt 20, dem dieselben Einstellungen der erfindungsgemäßen Triggereinheit 8 zugrunde liegen, wie dem Bildschirmausschnitt 20 aus Fig. 7A, weshalb in diesem Zusammenhang auf die Figurenbeschreibung von Fig. 7A verwiesen wird. In Fig. 7B tritt das Messsignal 2 zum Zeitpunkt 70 in den Hysteresebereich 30 ein und hat den Hysteresebereich 30 bei Erreichen der Triggerschwelle 25 zum Zeitpunkt 71 vollständig durchlaufen. Anschließend unterschreitet das Messsignal 2 die Triggerschwelle 25 während des Zeitbereichs 60 nicht nochmals, so dass mit Ende des Zeitbereichs 60 die Triggereinheit 8 das Triggersignal 9 an die Aufzeichnungseinheit 7 ausgibt.

Fig. 7C und 7D erläutern denselben Sachverhalt wie Fig. 7A und 7B mit der Ausnahme, dass die Triggereinheit 8 derart eingestellt ist, dass diese anstatt auf eine steigende Signalflanke des Messsignals 2 auf eine fallende Signalflanke des Messsignals 2 triggert. Dabei tritt das Messsignal 2, von einem hohen Pegel kommend, zum Zeitpunkt 70 in den Hysteresebereich 30 ein und hat den Hysteresebereich 30 bei Erreichen der Triggerschwelle 25 zum Zeitpunkt 71 vollständig durchlaufen bzw. durchschritten. Für den Fall, dass der Benutzer keinen Zeitbereich 60 eingestellt hätte, würde die Triggereinheit 8 ein Triggersignal 9 an die Aufzeichnungseinheit 7 ausgeben. Zu erkennen ist allerdings, dass das Messsignal 2 die Triggerschwelle 25 innerhalb des Zeitbereichs 60 im Zeitpunkt 72 erneut durchschreitet bzw. überschreitet, so dass im Folgenden die Triggereinheit 8 kein Triggersignal 9 ausgibt.

Fig. 7D zeigt ein Ausführungsbeispiel mit einem Bildschirmausschnitt 20, dem dieselben Einstellungen der erfindungsgemäßen Triggereinheit 8 zugrunde liegen, wie dem Bildschirmausschnitt 20 aus Fig. 7C. In Fig. 7D tritt das Messsignal 2 zum Zeitpunkt 70 in den Hysteresebereich 30 ein und hat den Hysteresebereich 30 bei Erreichen der Triggerschwelle 25 zum Zeitpunkt 71 vollständig durchlaufen. Anschließend überschreitet das Messsignal 2 die Triggerschwelle 25 während des Zeitbereichs 60 nicht nochmals, so dass mit Ende des Zeitbereichs 60 die Triggereinheit 8 das Triggersignal 9 an die Aufzeichnungseinheit 7 ausgibt.

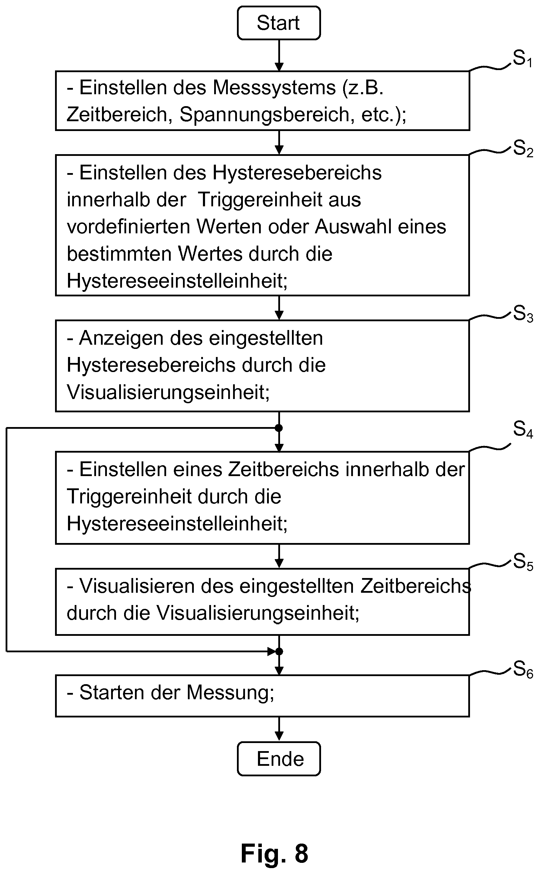

Fig. 8 zeigt ein beispielhaftes Ablaufdiagramm, welches das erfindungsgemäße Verfahren für die Messvorrichtung 1 beschreibt. In einem ersten Verfahrensschritt S₁ wird das Messgerät, bei welchem es sich z.B. um ein Oszilloskop handelt, entsprechend dem erwarteten zu messenden Messsignal 2 eingestellt. Dies geschieht durch einen Benutzer oder durch ein an das Messgerät angeschlossenes Computersystem. Eingestellt werden dabei allgemeine Parameter, wie z.B. der Zeitbereich und/oder der Pegelbereich, z.B. der Spannungsbereich bzw. Strombereich, und/oder die Triggerschwelle 25 und/oder der Triggerzeitpunkt 26 und/oder die Signalflanke auf die die Triggereinheit 8 triggert und/oder der zu messende Kanal und/oder der Abschlusswiderstand am Messeingang.

In einem zweiten Verfahrensschritt S₂ wird der Hysteresebereich 30 innerhalb der Triggereinheit 8 durch die Hystereseeinstelleinheit 13 eingestellt. Verschiedene Werte sind dabei für den Hysteresebereich 30 durch einen Benutzer oder durch ein an die Messvorrichtung 1 angeschlossenes Computersystem einstellbar. Bevorzugt ist der Hysteresebereich 30 beliebig einstellbar, wobei der Wortlaut beliebig insbesondere dahingehend zu verstehen ist, dass sich der Hysteresebereich 30 über den gesamten Auflösungsbereich des digitalen Komparators erstrecken kann. Weist der digitale Komparator z.B. eine Auflösung von 12 Bit auf, dann kann der Hysteresebereich 30 maximal in 2¹² Schritten genau eingestellt werden. Aufgrund der Tatsache, dass es im Stand der Technik bisher nicht möglich ist, den Hysteresebereich 30 einzustellen, kann daher, auch unter Würdigung dessen, was für eine ausreichend genaue Messung notwendig ist, davon gesprochen werden, dass der Hysteresebereich 30 beliebig einstellbar ist. Anders ausgedrückt bedeutet das, dass der Hysteresebereich 30 maximal entsprechend der Genauigkeit der digitalen Komparatoren innerhalb der Triggereinheit 8 eingestellt werden kann.

Sobald im Folgenden das mit einem Rauschsignal überlagerte Messsignal 2 den eingestellten Hysteresebereich 30 innerhalb der Triggereinheit 8 vollständig durchläuft, gibt die Triggereinheit 8 ein Triggersignal 9 an die Aufzeichnungseinheit 7 aus. Unter dem Wortlaut vollständig durchlaufen ist zu verstehen, dass das mit einem Rauschsignal überlagerte Messsignal 2 den Hysteresebereich 30 beginnend bei dem von der Triggerschwelle 25 am weit entferntesten Hysteresebereich 30 bis hin zur Triggerschwelle 25 durchlaufen muss. Anders ausgedrückt bedeutet dies, dass das mit einem Rauschsignal überlagerte Messsignal 2 den Hysteresebereich 30 vollständig in Richtung der Triggerschwelle 25 bzw. bis zum Erreichen der Triggerschwelle 25 durchlaufen muss, damit die Triggereinheit 8 ein Triggersignal 9 an die Aufzeichnungseinheit 7 ausgibt. Der Hysteresebereich 30 kann dabei in absoluten Werten wie z.B. 1 mV, 2 mV, 3 mV oder in Divisionen wie z.B. 0,5 Div, 1 Div, usw. eingestellt werden.

In einem dritten Verfahrensschritt S₃ zeigt die Visualisierungseinheit 12 innerhalb der Aufzeichnungseinheit 7, die mit der Hystereseeinstelleinheit 13 verbunden ist, den durch den Benutzer oder ein Computersystem eingestellten Hysteresebereich 30 auf einem Bildschirm an. Dabei wird der eingestellte Hysteresebereich 30 von der Visualisierungseinheit 12 durch eine eingefärbte und/oder transparente Fläche unterhalb oder oberhalb der Triggerschwelle 25 dargestellt. Ein automatisches Ausblenden des Hysteresebereichs 30 nach einer vorbestimmten bzw. ebenfalls einstellbaren Zeitdauer ist genauso möglich, wie auch das Anzeigen des Wertes für den Hysteresebereich 30 innerhalb der Statusanzeige 21.

Der Hysteresebereich 30 kann dabei auch aus einem von verschiedenen voreingestellten Werten ausgewählt werden. So können Werte für einen kleinen, einen mittleren und einen großen Hysteresebereich 30 direkt Bedienknöpfen an der Messvorrichtung 1 zugewiesen werden, um eine möglichst schnelle Einstellung zu erreichen. Auch ein automatisches Ermitteln des Hysteresebereichs 30 ist dabei möglich. Nach dem dritten Verfahrensschritt S₃ kann direkt der sechste Verfahrensschritt S₆ ausgeführt werden, in welchem die Messung gestartet wird.

Optional kann nach dem dritten Verfahrensschritt S₃ ein vierter Verfahrensschritt S₄ ausgeführt werden. Innerhalb dieses vierten Verfahrensschritts S₄ wird ein Zeitbereich 60 innerhalb der Triggereinheit 8 durch die Hystereseeinstelleinheit 13 eingestellt. Verschiedene Werte sind dabei für den Zeitbereich 60 durch einen Benutzer oder durch ein an die Messvorrichtung 1 angeschlossenes Computersystem einstellbar. Bevorzugt ist der Zeitbereich 60 beliebig einstellbar, wobei dies dahingehend zu verstehen ist, dass der Zeitbereich 30 in Schritten eingestellt werden kann, die so klein sind, wie der reziproke Teil der Frequenz, mit welcher das mit einem Rauschsignal überlagerte Messsignal 2 durch den Analog/Digital-Wandler 4 abgetastet wird. Anders ausgedrückt bedeutet dies, dass das Einstellen des Zeitbereichs 60 innerhalb der Hystereseeinstelleinheit 13 in Schritten erfolgt, die so klein sind, wie der reziproke Teil der Frequenz, mit welcher das mit einem Rauschsignal überlagerte Messsignal 2 durch den Analog/Digital-Wandler 4 abgetastet wird. Es kann dabei auch von einer bitgenauen Einstellung des Zeitbereichs 60 gesprochen werden. Im Folgenden wird durch die Triggereinheit 8 nur dann ein Triggersignal 9 an die Aufzeichnungseinheit 7 ausgegeben, wenn die Triggerschwelle 25 nur genau einmal zu Beginn des Zeitbereich 60 durch das mit einem Rauschsignal überlagerten Messsignals 2 über- oder unterschritten ist. Der Wortlaut zu Beginn des Zeitbereichs 26 ist äquivalent zu dem Wortlaut zum Triggerzeitpunkt 26.

Der Zeitbereich kann dabei in absoluten Werten wie z.B. 1 ns, 2 ns usw. gewählt werden, oder auch in Divisionen wie z.B. 0,5 Div, 1 Div, usw. eingestellt werden. Der Zeitbereich 60 kann auch aus einem von verschiedenen voreingestellten Werten ausgewählt werden, die bevorzugt direkt einem Bedienknopf zugewiesen sind, um dadurch ein möglichst schnelles Einstellen der Messvorrichtung 1 zu erreichen. Auch ein automatisches Ermitteln des Zeitbereichs 60 durch die Messvorrichtung 1 selbst kann eingestellt werden.

In einem fünften Verfahrensschritt S₅ wird der eingestellte Zeitbereich 60 durch die Visualisierungseinheit 12 für den Benutzer auf einem Bildschirm angezeigt. Bevorzugt wird der eingestellte Zeitbereich 60 dabei von der Visualisierungseinheit 12 durch eine eingefärbte und/oder transparente Fläche neben dem Triggerzeitpunkt 26 entlang der positiven Zeitachse dargestellt. Ein automatisches Ausblenden des Zeitbereichs 60 nach einer vorbestimmten bzw. ebenfalls einstellbaren Zeitdauer ist ebenfalls möglich, wie auch das Anzeigen des Wertes für den Zeitbereich 60 innerhalb der Statusanzeige 21.

Nach Abschluss des fünften Verfahrensschritts S₅ wird der bereits zuvor erläuterte sechste Verfahrensschritt S₆ ausgeführt. Hervorzuheben ist, dass es besonders vorteilhaft ist, wenn es sich bei der Triggereinheit 8 um eine digitale Triggereinheit 8 handelt und/oder wenn das mit einem Rauschsignal überlagerte Messsignal 2 digitalisiert ist, weil ansonsten der Hysteresebereich 30 über ein Widerstandsnetzwerk an den analogen Komparatoren eingestellt werden müsste, welches eine derart feine Einstellung, wie bei Verwendung von digitalen Komparatoren, nicht zulässt und zudem das Rauschen erhöht.

Wichtig ist weiterhin, dass der Zeitbereich 60 auch aktiviert sein kann, wenn der Hysteresebereich 30 deaktiviert ist, wobei bei aktiviertem Zeitbereich 60 und aktiviertem Hysteresebereich 30, das mit einem Rauschen überlagerte Messsignal 2 deutlich besser getriggert werden kann und ein Fehlauslösen der Triggereinheit 8 dadurch nochmals reduziert werden kann.

Die Messvorrichtung 1, bei welcher es sich insbesondere um ein digitales Speicheroszilloskop handelt, kann entweder durch einen Benutzer oder durch ein mit der Messvorrichtung 1 verbundenes Computersystem eingestellt und gesteuert werden. Bei letzterem ist die Messvorrichtung 1 z.B. über eine LAN-Schnittstelle (engl. local area network; dt. lokales Netzwerk) und/oder eine USB-Schnittstelle (engl. universal serial bus; dt. universeller serieller Bus) und/oder eine GPIB-Schnittstelle (engl. general purpose interface bus; dt. Schnittstellenbus für allgemeine Zwecke) mit dem Computersystem verbunden, wobei die Befehle zum Steuern der Messvorrichtung 1 bevorzugt als SCPI-Befehle (engl. standard commands for programmable instruments; dt. Standardbefehle für programmierbare Messgeräte) kodiert sind.

Im Rahmen der Erfindung sind alle beschriebenen und/oder gezeichneten Merkmale beliebig miteinander kombinierbar. Die Triggerung kann auch bei einem anderen Messgerät als bei einem Oszilloskop zum Einsatz kommen.

## Patentansprüche

1. Messvorrichtung (1) zur Triggerung eines mit einem Rauschsignal überlagerten Messsignals (2), aufweisend eine Aufzeichnungseinheit (7), eine Triggereinheit (8) und eine Hystereseeinstelleinheit (13), wobei die Triggereinheit (8) mit der Aufzeichnungseinheit (7) verbunden ist,
- wobei der Triggereinheit (8) und der Aufzeichnungseinheit (7) das jeweils mit einem Rauschsignal überlagerte Messsignal (2) zugeführt ist,
- wobei die Triggereinheit (8) ausgebildet ist, um ein Triggersignal (9) an die Aufzeichnungseinheit (7) auszugeben, sobald das mit einem Rauschsignal überlagerte Messsignal (2) einen Hysteresebereich (30) vollständig durchlaufen hat,
- wobei die Triggereinheit (8) mit der Hystereseeinstelleinheit (13) verbunden ist,
- wobei die Hystereseeinstelleinheit (13) einen Hysteresebereich (30) der Triggereinheit (8) vorgibt und der von der Hystereseeinstelleinheit (13) vorgegebene Hysteresebereich (30) einstellbar ist und
- wobei die Aufzeichnungseinheit (7) eine Visualisierungseinheit (12) aufweist, die mit der Hystereseeinstelleinheit (13) verbunden ist,
**dadurch gekennzeichnet,**
**dass** der von der Hystereseeinstelleinheit (13) vorgegebene Hysteresebereich (30) entsprechend der Genauigkeit von digitalen Komparatoren bitgenau einstellbar ist und
**dass** dieser entsprechend der Genauigkeit der digitalen Komparatoren bitgenau eingestellte Hysteresebereich (30) von der Visualisierungseinheit (12) durch eine transparente Fläche mit einem geringeren Kontrast als das Messsignal(2) unterhalb oder oberhalb einer Triggerschwelle (25) in einer anderen als irgendeinem Messkanal der Messvorrichtung (1) zugewiesenen Farbe entlang einer horizontalen Achse der Visualisierungseinheit (12) dargestellt ist.

2. Messvorrichtung nach Anspruch 1,
**dadurch gekennzeichnet,**
**dass** die Hystereseeinstelleinheit (13) einen Zeitbereich (60) innerhalb der Triggereinheit (8) beliebig einstellt, wobei die Triggereinheit (8) ausgebildet ist, um das Triggersignal (9) nur an die Aufzeichnungseinheit (7) auszugeben, wenn eine Triggerschwelle (25) genau einmal zu Beginn des Zeitbereichs (60) über- oder unterschritten ist.

3. Messvorrichtung nach einem der vorhergehenden Ansprüche,
**dadurch gekennzeichnet,**
**dass** es sich bei der Triggereinheit (8) um eine digitale Triggereinheit (8) handelt und/oder dass das mit einem Rauschsignal überlagerte Messsignal (2) digitalisiert ist.

4. Messvorrichtung nach Anspruch 3,
**dadurch gekennzeichnet,**
**dass** für den Hysteresebereich (30) und/oder für den Zeitbereich (60) verschiedene Werte einstellbar sind und/oder dass der Hysteresebereich (30) und/oder der Zeitbereich (60) in der Hystereseeinstelleinheit (13) bitgenau einstellbar ist und/oder dass der Hysteresebereich (30) und/oder der Zeitbereich (60) aus einem von verschiedenen voreingestellten Werten auswählbar ist.

5. Messvorrichtung nach einem der vorhergehenden Ansprüche,
**dadurch gekennzeichnet,**
**dass** die Aufzeichnungseinheit (7) eine Visualisierungseinheit (12) aufweist, die mit der Hystereseeinstelleinheit (13) verbunden ist und den eingestellten Hysteresebereich (30) und den eingestellten Zeitbereich (60) anzeigt.

6. Messvorrichtung nach Anspruch 5,
**dadurch gekennzeichnet,**
**dass** der eingestellte Hysteresebereich (30) von der Visualisierungseinheit (12) durch eine eingefärbte und transparente Fläche unterhalb oder oberhalb der Triggerschwelle (25) dargestellt ist und/oder dass der eingestellte Zeitbereich (60) von der Visualisierungseinheit (12) durch eine eingefärbte und transparente Fläche seitlich neben dem Triggerzeitpunkt (26) dargestellt ist.

7. Messvorrichtung nach einem der vorhergehenden Ansprüche,
**dadurch gekennzeichnet,**
**dass** der Hysteresebereich (30) und/oder der Zeitbereich (60) in absoluten Werten oder in Divisionen einstellbar ist.

8. Verfahren zur Triggerung eines mit einem Rauschsignal überlagerten Messsignals (2), aufweisend eine Triggereinheit (8), die mit einer Aufzeichnungseinheit (7) verbunden ist, wobei der Triggereinheit (8) und der Aufzeichnungseinheit (7) das jeweils mit einem Rauschsignal überlagerte Messsignal (2) zugeführt wird und wobei eine Hystereseeinstelleinheit (13) mit der Triggereinheit (8) verbunden ist und
wobei die Aufzeichnungseinheit (7) eine Visualisierungseinheit (12) aufweist, die mit der Hystereseeinstelleinheit (13) verbunden ist,
mit folgenden Verfahrensschritten:
- Einstellen (S₁) von Parametern, insbesondere Zeit- und/oder Pegelbereich;
- Bitgenaues Einstellen (S₂) eines Hysteresebereichs (30) entsprechend der Genauigkeit von digitalen Komparatoren für die Triggereinheit (8) durch die Hystereseeinstelleinheit (13), wobei die Triggereinheit (8) ein Triggersignal (9) an die Aufzeichnungseinheit (7) ausgibt, sobald das mit einem Rauschsignal überlagerte Messsignal (2) den Hysteresebereich (30) innerhalb der Triggereinheit (8) vollständig durchläuft;
- Anzeigen (S₃) des entsprechend der Genauigkeit der digitalen Komparatoren bitgenau eingestellten Hysteresebereichs (30) durch die Visualisierungseinheit (12) durch eine transparente Fläche mit einem geringeren Kontrast als dem Messsignal (2) unterhalb oder oberhalb einer Triggerschwelle (25) in einer anderen als irgendeinem Messkanal der Messvorrichtung (1) zugewiesenen Farbe entlang einer horizontalen Achse der Visualisierungseinheit (12).

9. Verfahren nach Anspruch 8,
wobei das Verfahren weiterhin den nachfolgenden Verfahrensschritt aufweist:
- Einstellen (S₄) eines Zeitbereichs (60) innerhalb der Triggereinheit (8) durch die Hystereseeinstelleinheit (13), wobei das Einstellen des Zeitbereichs (60) innerhalb der Hystereseeinstelleinheit (13) beliebig erfolgt und wobei die Triggereinheit (8) das Triggersignal (9) an die Aufzeichnungseinheit (7) nur ausgibt, wenn eine Triggerschwelle (25) genau einmal zu Beginn des Zeitbereichs (26) über- oder unterschritten ist.

10. Verfahren nach Anspruch 9,
wobei das Verfahren weiterhin den nachfolgenden Verfahrensschritt aufweist:
- Darstellen (S₅) des eingestellten Zeitbereichs (60) durch die Visualisierungseinheit (12).

11. Verfahren nach einem der Ansprüche 8 bis 10,
wobei es sich bei der Triggereinheit (8) um eine digitale Triggereinheit (8) handelt und/oder dass das mit einem Rauschsignal überlagerte Messsignal (2) digitalisiert ist.

## Claims

1. Measuring device (1) for triggering a measurement signal (2) overlaid with a noise signal, comprising a recording unit (7), a trigger unit (8) and a hysteresis setting unit (13), the trigger unit (8) being connected with the recording unit (7),
- wherein the measurement signal (2) overlaid in each case with a noise signal is fed to the trigger unit (8) and the recording unit (7),
- wherein the trigger unit (8) is configured to output a trigger signal (9) to the recording unit (7) as soon as the measurement signal (2) overlaid with a noise signal has run through a hysteresis range (30) completely,
- wherein the trigger unit (8) is connected with the hysteresis setting unit (13),
- wherein the hysteresis setting unit (13) presets a hysteresis range (30) for the trigger unit (8) and the hysteresis range (30) preset by the hysteresis setting unit (13) is adjustable and
- wherein the recording unit (7) has a visualisation unit (12) which is connected with the hysteresis setting unit (13),
**characterised in that**
the hysteresis range (30) preset by the hysteresis setting unit (13) is adjustable with bit precision according to the accuracy of digital comparators and **in that** this hysteresis range (30) preset with bit precision according to the accuracy of the digital comparators is displayed by the visualisation unit (12) by a transparent area with a lower contrast than the measurement signal (2) below or above a trigger threshold (25) in a different colour to that assigned to any measurement channel of the measuring device (1) along a horizontal axis of the visualisation unit (12).

2. Measuring device according to claim 1,
**characterised in that**
the hysteresis setting unit (13) arbitrarily sets a time range (60) within the trigger unit (8), the trigger unit (8) being configured to output the trigger signal (9) to the recording unit (7) only when a trigger threshold (25) is overshot or undershot just once at the beginning of the time range (60).

3. Measuring device according to one of the preceding claims,
**characterised in that**
the trigger unit (8) is a digital trigger unit (8) and/or in that the measurement signal (2) overlaid with a noise signal is digitized.

4. Measuring device according to claim 3,
**characterised in that**
different values can be set for the hysteresis range (30) and/or for the time range (60) and/or **in that** the hysteresis range (30) and/or the time range (60) is adjustable with bit precision in the hysteresis setting unit (13) and/or **in that** the hysteresis range (30) and/or the time range (60) can be selected from one of different preset values.

5. Measuring device according to one of the preceding claims,
**characterised in that**
the recording unit (7) comprises a visualisation unit (12) which is connected with the hysteresis setting unit (13) and displays the set hysteresis range (30) and the set time range (60).

6. Measuring device according to claim 5,
**characterised in that**
the set hysteresis range (30) is displayed by the visualisation unit (12) by a coloured and transparent area below or above the trigger threshold (25) and/or **in that** the set time range (60) is displayed by the visualisation unit (12) by a coloured and transparent area at the side next to the trigger time (26).

7. Measuring device according to one of the preceding claims,
**characterised in that**
the hysteresis range (30) and/or the time range (60) is adjustable in absolute values or in divisions.

8. Method for triggering a measurement signal (2) overlaid with a noise signal, implementing a trigger unit (8) which is connected with a recording unit (7),
wherein the measurement signal (2) overlaid in each case with a noise signal is fed to the trigger unit (8) and the recording unit (7) and
wherein a hysteresis setting unit (13) is connected with the trigger unit (8) and
wherein the recording unit (7) comprises a visualisation unit (12) which is connected with the hysteresis setting unit (13),
with the following method steps:
- setting (S₁) of parameters, in particular time range and/or level range;
- setting (S₂) with bit precision of a hysteresis range (30) according to the accuracy of digital comparators for the trigger unit (8) by the hysteresis setting unit (13), wherein the trigger unit (8) outputs a trigger signal (9) to the recording unit (7) as soon as the measurement signal (2) overlaid with a noise signal runs through the hysteresis range (30) within the trigger unit (8) completely;
- displaying (S₃) of the hysteresis range (30) set with bit precision according to the accuracy of the digital comparators by the visualisation unit (12) by a transparent area with a lower contrast than the measurement signal (2) below or above a trigger threshold (25) in a different colour to that assigned to any measurement channel of the measuring device (1) along a horizontal axis of the visualisation unit (12).

9. Method according to claim 8,
wherein the method also comprises the following method step:
- setting (S₄) of a time range (60) within the trigger unit (8) by the hysteresis setting unit (13), wherein the setting of the time range (60) within the hysteresis setting unit (13) is effected arbitrarily and wherein the trigger unit (8) outputs the trigger signal (9) to the recording unit (7) only when a trigger threshold (25) is overshot or undershot just once at the beginning of the time range (26).

10. Method according to claim 9,
wherein the method also comprises the following method step:
- displaying (S₅) of the set time range (60) by the visualisation unit (12).

11. Method according to one of claims 8 to 10,
wherein the trigger unit (8) is a digital trigger unit (8) and/or the measurement signal (2) overlaid with a noise signal is digitized.

## Revendications

1. Dispositif de mesure (1) pour le déclenchement d'un signal de mesure (2) superposé à un signal de bruit, comportant une unité d'enregistrement (7), une unité de déclenchement (8) et une unité de réglage de l'hystérésis (13), dans lequel l'unité de déclenchement (8) est raccordée à l'unité d'enregistrement (7),
- dans lequel le signal de mesure (2) superposé respectivement à un signal de bruit est acheminé à l'unité de déclenchement (8) et l'unité d'enregistrement (7),
- dans lequel l'unité de déclenchement (8) est conçue pour délivrer un signal de déclenchement (9) en direction de l'unité d'enregistrement (7) dès que le signal de mesure (2) superposé à un signal de bruit a totalement parcouru la plage d'hystérésis (30),
- dans lequel l'unité de déclenchement (8) est raccordée à l'unité de réglage de l'hystérésis (13),
- dans lequel l'unité de réglage de l'hystérésis (13) prédéfinit une plage d'hystérésis (30) de l'unité de déclenchement (8) et la plage d'hystérésis (30) prédéfinie par l'unité de réglage de l'hystérésis (13) est réglable et
- dans lequel l'unité d'enregistrement (7) comporte une unité de visualisation (12) qui est raccordée à l'unité de réglage de l'hystérésis (13),
**caractérisé**
**en ce que** la plage d'hystérésis (30) prédéfinie par l'unité de réglage de l'hystérésis (13) est réglable au bit près conformément à la précision de comparateurs numériques et en ce que cette plage d'hystérésis (30) réglée au bit près conformément à la précision des comparateurs numériques est représentée par l'unité de visualisation (12) par une surface transparente avec un contraste plus faible que le signal de mesure (2) en dessous ou au-dessus d'un seuil de déclenchement (25) dans une autre couleur assignée en tant que canal de mesure quelconque du dispositif de mesure (1) le long d'un axe horizontal de l'unité de visualisation (12).

2. Dispositif de mesure selon la revendication 1,
**caractérisé**
**en ce que** l'unité de réglage de l'hystérésis (13) règle arbitrairement une plage temporelle (60) à l'intérieur de l'unité de déclenchement (8), dans lequel l'unité de déclenchement (8) est conçue pour ne délivrer le signal de déclenchement (9) en direction de l'unité d'enregistrement (7) que si un seuil de déclenchement (25) est dépassé ou n'est pas atteint précisément une fois au début de la plage temporelle (60) .

3. Dispositif de mesure selon l'une des revendications précédentes,
**caractérisé**
**en ce que** l'unité de déclenchement (8) est une unité de déclenchement (8) numérique et/ou en ce que le signal de mesure (2) superposé à un signal de bruit est numérisé.

4. Dispositif de mesure selon la revendication 3,
**caractérisé**
**en ce que** différentes valeurs sont réglables pour la plage d'hystérésis (30) et/ou pour la plage temporelle (60) et/ou en ce que la plage d'hystérésis (30) et/ou la plage temporelle (60) sont/est réglable(s) au bit près dans l'unité de réglage de l'hystérésis (13) et/ou en ce que la plage d'hystérésis (30) et/ou la plage temporelle (60) peuvent/peut être sélectionnée(s) à partir d'une valeur parmi différentes valeurs préréglées.

5. Dispositif de mesure selon l'une des revendications précédentes,
**caractérisé**
**en ce que** l'unité d'enregistrement (7) comporte une unité de visualisation (12) qui est raccordée à l'unité de réglage de l'hystérésis (13) et indique la plage d'hystérésis (30) réglée et la plage temporelle (60) réglée.

6. Dispositif de mesure selon la revendication 5,
**caractérisé**
**en ce que** la plage d'hystérésis (30) réglée est représentée par l'unité de visualisation (12) par une surface colorée et transparente en dessous ou au-dessus du seuil de déclenchement (25) et/ou en ce que la plage temporelle (60) réglée est représentée par l'unité de visualisation (12) par une surface colorée et transparente latéralement à côté du moment de déclenchement (26).

7. Dispositif de mesure selon l'une des revendications précédentes,
**caractérisé**
**en ce que** la plage d'hystérésis (30) et/ou la plage temporelle (60) sont/est réglable(s) en valeurs absolues ou en fractions.

8. Procédé de déclenchement d'un signal de mesure (2) superposé à un signal de bruit, comportant une unité de déclenchement (8), qui est raccordée à une unité d'enregistrement (7), dans lequel le signal de mesure (2) superposé respectivement à un signal de bruit est acheminé à l'unité de déclenchement (8) et l'unité d'enregistrement (7), et dans lequel une unité de réglage de l'hystérésis (13) est raccordée à l'unité de déclenchement (8) et dans lequel l'unité d'enregistrement (7) comporte une unité de visualisation (12), qui est raccordée à l'unité de réglage de l'hystérésis (13), ledit procédé comportant les étapes de procédé suivantes :
- réglage (S₁) de paramètres, en particulier de la plage temporelle et/ou de la plage de niveaux ;
- réglage au bit près (S₂) d'une plage d'hystérésis (30) par l'unité de réglage de l'hystérésis (13) pour l'unité de déclenchement (13) conformément à la précision des comparateurs numériques, dans lequel l'unité de déclenchement (8) délivre un signal de déclenchement (9) en direction de l'unité d'enregistrement (7), dès que le signal de mesure (2) superposé à un signal de bruit parcourt totalement la plage d'hystérésis (30) à l'intérieur de l'unité de déclenchement (8) ;
- affichage (S₃) de la plage d'hystérésis (30) réglée au bit près conformément à la précision des comparateurs numériques par l'unité de visualisation (12) par une surface transparente avec un contraste plus faible que le signal de mesure (2) en dessous ou au-dessus d'un seuil de déclenchement (25) dans une autre couleur assignée en tant que canal de mesure quelconque du dispositif de mesure (1) le long d'un axe horizontal de l'unité de visualisation (12).

9. Procédé selon la revendication 8,
dans lequel le procédé comporte en outre l'étape de procédé suivante :
- réglage (S₄) d'une plage temporelle (60) à l'intérieur de l'unité de déclenchement (8) par l'unité de réglage de l'hystérésis (13), dans lequel le réglage de la plage temporelle (60) se fait arbitrairement à l'intérieur de l'unité de réglage de l'hystérésis (13) et dans lequel l'unité de déclenchement (8) ne délivre le signal de déclenchement (9) en direction de l'unité d'enregistrement (7) que si un seuil de déclenchement (25) est dépassé ou n'est pas atteint précisément une fois au début de la plage temporelle (26).

10. Procédé selon la revendication 9,
dans lequel le procédé comporte en outre l'étape de procédé suivante :
- représentation (S₅) de la plage temporelle (60) réglée par l'unité de visualisation (12).

11. Procédé selon l'une des revendications 8 à 10,
dans lequel l'unité de déclenchement (8) est une unité de déclenchement (8) numérique et/ou le signal de mesure (2) superposé à un signal de bruit étant numérisé.
